# EUROPEAN PATENT APPLICATION

(11) **EP 4 303 069 A1**
(43) Date of publication of application: **10.01.2024**
(21) Application number: 22182820.5
(22) Date of filing: 04.07.2022
(51) Int. Cl.: B60L 58/12, B60L 58/16, B60L 3/12

(54) **A METHOD FOR ESTIMATING A POWER OR CURRENT LIMIT FOR AN ELECTRICAL ENERGY STORAGE SYSTEM**

(71) Applicant: VOLVO TRUCK CORPORATION, 405 08 Göteborg (SE)
(72) Inventor: SINGH, Gurpreet, SE-421 39 GÖTEBORG (SE); CHOI, YoungJin, SE-421 73 VÄSTRA FRÖLUNDA (SE)
(74) Representative: Kransell & Wennborg KB

(57) **Abstract**

The invention relates to a method for estimating a power or current limit for an electrical energy storage system (2), the method comprising: obtaining (S102) vehicle fleet data indicating power usage of a fleet (4) of vehicles (1) in a geographical area (6); categorizing (S104) the vehicle fleet data into a set of power usage profiles (10, 20, 30) depending on an expected amount of power usage determined from the vehicle fleet data; calculating (S106) a time dependent averaged current profile (12) from a distribution of the power usage profiles; and applying (S108) the time dependent averaged current profile (12) to an electrical energy storage cell (3) to age the electrical energy storage cell to a predetermined state of health, and determining (S110) the power or current limit (14) for the electrical energy storage cell.

## Description

### TECHNICAL FIELD

The present disclosure relates to a method for estimating a power or current limit for an electrical energy storage system. The present disclosure also relates to a corresponding system, control unit, and computer program. Although the method and system will be described in relation to a vehicle in the form of a truck, the method and system can also be efficiently incorporated in other vehicle types such as busses, light-weight trucks, passenger cars, construction equipment and marine vessels and industrial equipment, as long as they are at least partly electrically propelled.

### BACKGROUND

Batteries are becoming a more common source of power for providing propulsion power to vehicles. Such batteries are rechargeable batteries and consist of several battery cells that may be connected in series and/or in parallel forming a complete battery pack for the vehicle.

Propulsion batteries are subject to current and power limits to ensure reliable operation over time down to a certain state of health level of the battery pack. The current and power limits are determined prior to taking the battery in full operation by a user.

The current and power limits of the battery pack are calculated from battery cell current limits by using a flat C-rate aging process. In such tests a constant power output of the battery is assumed. However, in real-world applications the current and power outtake is typically not constant which means that the flat C-rate aging process often leads to conservative or overestimated power levels.

Accordingly, it is desirable to improve estimations of current and power limits for propulsion batteries to better reflect a realistic usage of the batteries.

### SUMMARY

An object of the invention is to provide an improved method for estimating a power or current limit for an electrical energy storage system.

According to a first aspect of the invention, the object is achieved by a method according to claim 1.

According to the first aspect of the invention, there is provided a method for estimating a power or current limit for an electrical energy storage system. The method comprising obtaining vehicle fleet data indicating power usage of a fleet of vehicles in a geographical area. Further, the method comprises categorizing the vehicle fleet data into a set of power usage profiles depending on an expected amount of power usage determined from the vehicle fleet data. Calculating a time dependent averaged current profile from a distribution of the power usage profiles. Applying the time dependent averaged current profile to an electrical energy storage cell to age the electrical energy storage cell to a predetermined state of health and determining the power or current limit for the electrical energy storage cell.

The power or current limit for the electrical energy storage cell is determined once the energy storage cell has been aged to the predetermined state of health.

The present invention is based on the realization to use vehicle driving and power usage data from a fleet of vehicles to generate a current profile that reflects an expected driving behaviour of users to in this way age the energy storage cell more realistically. In this way, the power or current limits of the energy storage cells will be accurately set according to the way an average user drives a vehicle.

The time dependent averaged current profile reflects corresponding portions of power usage according to the distribution of the power usage profiles. For example, if 10% of the users belong to low or "mild" power usage, 20% belong to medium power usage and 70% belong to high or "harsh" power usage then the time dependent averaged current profile includes corresponding portions of current or power profiles. Stated otherwise, the time dependent averaged current profile is applied so that portions of the time dependent averaged current profile include respective proportions of mild power usage, medium power usage, and high-power usage, or generally corresponding proportions from the categorized power usage profiles.

Thus, by the provision of using field data from vehicles that are driven in real-world situations a more realistic power or current limit can be determined to thereby provide improved electric energy storage system, or battery, utilization for the end user. The vehicle fleet data may thus advantageously be field data collected from vehicles operating in real-world conditions operated by multiple drivers in the geographical area over some time, preferably from a "big data" perspective, e.g., the more data gives higher confidence.

State of health may be defined as the loss in capacity relative a capacity at the beginning of life of the battery, so -called state of capacity, or the internal resistance increase of the battery relative the internal resistance at the beginning of life of the battery, so called state of resistance. These state of health parameters are well established and advantageously relatively straight-forward to measure.

State of charge which is mentioned herein is the present level of charge in the battery compared to its full capacity and may be given as a percentage value.

The energy storage system may be a propulsion battery and should be interpreted as being configured to provide propulsion energy to a vehicle once deployed. Such battery comprises multiple electrical energy storage cells, or battery cells, electrically connected in series and parallel. The vehicle may be an electrical, hybrid, or plug-in hybrid vehicle comprising an electrical engine, wherein the battery provides power to the electrical engine for providing propulsion for the electrical, hybrid, or plug-in hybrid vehicle. The battery may be Li-ion battery comprising multiple cells arranged in series and in parallel as is known in the art.

In the step of determining the current or power limits, methods such as hybrid pulse power characterization (HPPC) or so-called I-V methods may be employed.

According to an example embodiment, the method may comprise determining state of charge limits from the vehicle fleet data and applying the time dependent averaged current profile with limits according to the state of charge limits. In other words, state of charge limits is determined based on the overall or average state of charge that can be derived from the vehicle fleet data. The state of charge limits is superimposed on the time dependent averaged current profile to account for the state of charge limits.

According to an example embodiment, the method may comprise categorizing state of charge usage from the vehicle fleet data into a set of state of charge profiles depending on state of charge usage derived from the vehicle fleet data and determining state of charge limits from the categorized state of charge usage. Categorizing the state of charge profiles provides for a more accurate inclusion of the state of charge limits that reflect the behaviour of the users in the vehicle fleet from which the vehicle fleet data is acquired. Thus, the time dependent averaged current profile is applied so that state of charge limits according to the state of charge profiles are applied with respective proportions.

According to an example embodiment, the method may comprise determining depth of discharge limits from the vehicle fleet data and applying the time dependent averaged current profile with limits according to the depth of discharge limits. In other words, depth of discharge limits is determined based on the overall or average depth of discharge that can be derived from the vehicle fleet data. The depth of discharge limits is superimposed on the time dependent averaged current profile to account for the depth of discharge limits.

According to an example embodiment, the method may comprise categorizing depth of discharge from the vehicle fleet data into a set of depth of discharge profiles depending on depth of discharge usage derived from the vehicle fleet data, and determining depth of discharge limits from the categorized depth of discharge usage. Categorizing the depth of discharge limits provides for a more accurate inclusion of the depth of discharge limits that reflect the behaviour of the users in the vehicle fleet from which the vehicle fleet data is acquired. Thus, the time dependent averaged current profile is applied so that depth of discharge limits according to the depth of discharge profiles are applied with respective proportions.

According to an example embodiment, the method may comprise determining a charging behaviour from the vehicle fleet data and charging to the battery cell according to the charging behaviour. The more user behaviours that can be included the more accurate the current or power limit determination becomes. One such behaviour is the charging behaviour that can be superimposed when applying the time dependent averaged current profile.

According to an example embodiment, the charging behaviour may include a distribution of charging rates including at least two different charging rates.

According to an example embodiment, calculating a time dependent averaged current profile may comprise calculating a root-mean-square of the categorized vehicle fleet data. The root-mean-square is calculated on a time period of the data using so-called window-averaging, for example in windows of 1s, 10s, 100s, 1000s, etc, depending on the time scale of interest for the implementation at hand.

According to an example embodiment, the set of profiles may comprise three types or levels of vehicle usage. More profiles provide for a more realistic distribution of the power usage that better reflect the real-world usage and therefore also the correspondence between the determine current or power limits and real-world usage captured in the vehicle fleet data.

According to an example embodiment, categorizing the vehicle fleet data may comprise processing the vehicle fleet data in a neural network. Example artificial neural networks include support vector machines and convolutional neural networks, or other fitted empirical models.

According to an example embodiment, the vehicle fleet data may be retrieved from a server. The data may thus be stored in a cloud-based service to which vehicles upload their vehicle data indicative of power usage in a given geographical area. This data is accessible to a control unit for determining the current or power limits according to the method disclosed herein.

According to a second aspect of the invention, there is provided a computer program comprising program code means for performing the steps the first aspect when the program is run on a computer.

According to a third aspect of the invention, there is provided a computer readable medium carrying a computer program comprising program code means for performing the steps of the first aspect when the program product is run on a computer.

According to a fourth aspect of the invention, there is provided control unit for estimating a power or current limit for an electrical energy storage system, the control unit being configured to perform the steps of the method according to the first aspect.

According to a fifth aspect of the invention, there is provided an electrical energy storage system comprising at least one electrical energy storage cell, wherein an power or an current limit for the electrical energy storage cell is determined using the steps of the method according to the first aspect.

Effects and features of the second, third, fourth, and fifth aspects are largely analogous to those described above in relation to the first aspect.

Further features of, and advantages will become apparent when studying the appended claims and the following description. The skilled person will realize that different features may be combined to create embodiments other than those described in the following, without departing from the scope of the present disclosure.

### BRIEF DESCRIPTION OF THE DRAWINGS

With reference to the appended drawings, below follows a more detailed description of embodiments of the invention cited as examples.

In the drawings:
Fig. 1 is a vehicle in the form an electrical truck according to example embodiments of the invention;
Fig. 2 is a block diagram of illustrating an overview of a control unit operation according to example embodiments of the invention.
Fig. 3 is a flow-chart of method steps according to example embodiments of the invention;
Fig. 4 is a flow-chart of method steps according to example embodiments of the invention;
Fig. 5 is a flow-chart of method steps according to example embodiments of the invention;
Fig. 6 is a flow-chart of method steps according to example embodiments of the invention; and
Fig. 7 is a functional flow-chart of embodiments of the invention.

### DETAILED DESCRIPTION OF EXAMPLE EMBODIMENTS OF THE INVENTION

The present invention will now be described more fully hereinafter with reference to the accompanying drawings, in which exemplary embodiments of the invention are shown. The invention may, however, be embodied in many different forms and should not be construed as limited to the embodiments set forth herein; rather, these embodiments are provided for thoroughness and completeness. The skilled person will recognize that many changes and modifications may be made within the scope of the appended claims. Like reference character refer to like elements throughout the description.

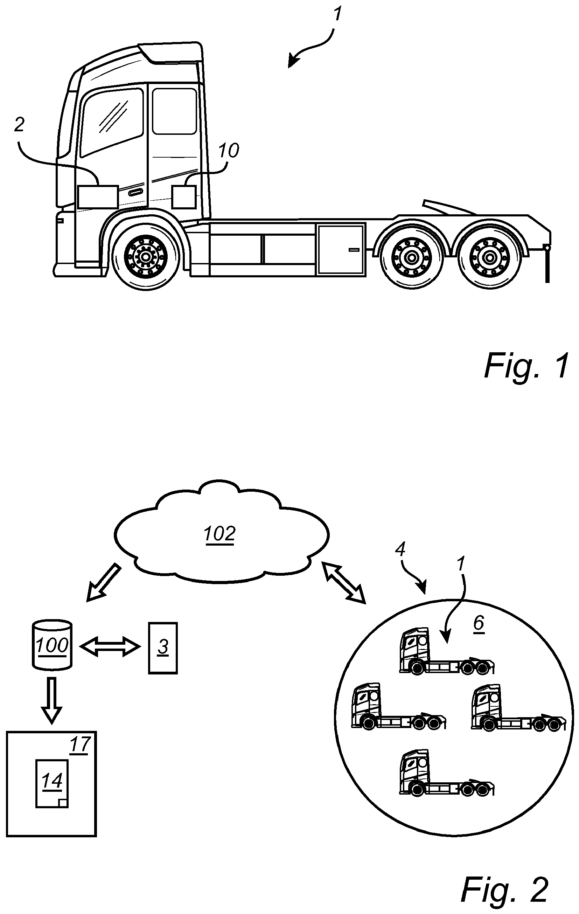

Fig. 1 illustrates a vehicle in the form of an electrical truck 1 comprising a propulsion battery 2 generally comprising a plurality of series and parallel connected battery cells. The propulsion battery 2 is arranged to provide power to an electrical engine (not shown) arranged for providing propulsion for the electrical truck 1. The electrical truck 1 further comprises a battery managing system 10 which is configured to monitor battery cell characteristics such as state of charge, battery voltage, and optionally temperature of the battery cells, and to predict the remaining useful lifetime the propulsion battery 2, as will be discussed further herein. The propulsion battery 2 may be a Li-ion battery.

Although the vehicle in fig. 1 is depicted as a heavy-duty truck, embodiments of the present disclosure may as well be implemented in other types of vehicles, such as in busses, light-weight trucks, passenger cars, construction equipment, industrial applications, and marine applications including e.g., vessels or ships.

In use, the battery 2 is subject to current or power limits that constraint the available power outtake from the battery 2. The current or power limits are set so that the battery can reliably provide the same power output to the vehicle 2 over a given time period. The end user should expect the same, or similar power from the battery over the time period without excessive degradation of the battery 2 performance. Embodiments disclosed herein address how to improve the estimation of the current or power limits so that they better reflect actual usage of a vehicle.

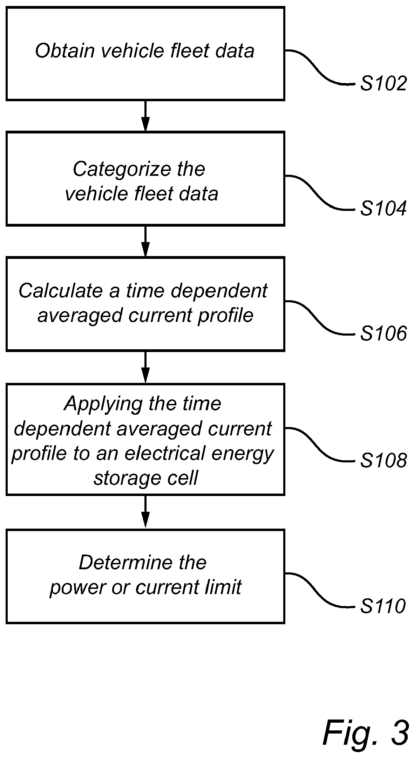

Fig. 2 is a block diagram and figs. 3-6 are flow-charts of embodiments of the present invention. The flow-charts in figs. 3-6 will be described in conjunction with the block diagram in fig. 2.

In step S102, vehicle fleet data is obtained by the control unit 100 indicating power usage of a fleet 4 of vehicles 1 in a geographical area 6. The vehicle fleet data may be retrieved via a server hosting a cloud-based service 102. Thus, the vehicle fleet data may be acquired and stored on a remote server until the control unit 100 acquires the vehicle fleet data from the storage on the server. The vehicles 1 are thus equipped with wireless transmission units configured to transmit the vehicle data to the cloud-based service 102. The vehicles 1 may be configured to continuously transmit their vehicle data to the cloud-based service 102.

The vehicle fleet data indicates power usage in the specific geographical area 6. This means that the vehicle fleet data reflects the vehicle usage or performance in the specific topology of the geographical area 6. Further, the vehicle fleet data also depend on the road conditions, number of vehicles, climate, and other factors specific to that geographical area 6.

The vehicle fleet data is indicative of the power usage of the vehicles. In other words, the power output form the batteries of the vehicles 6, or the torque provided by the engines of the vehicles 6 as a function of time. The vehicle fleet data may reflect power usage, e.g., torque output data from both electrified vehicles and combustion engine vehicles. Other data included in the vehicle fleet data may include the state of charge upper and lower levels of the batteries of electrified vehicles during operation, or the depth of discharge of the batteries, or charging cycle data indicating for example the speed of charging amount of charging and charging frequency, i.e., how often the vehicle battery is being charged.

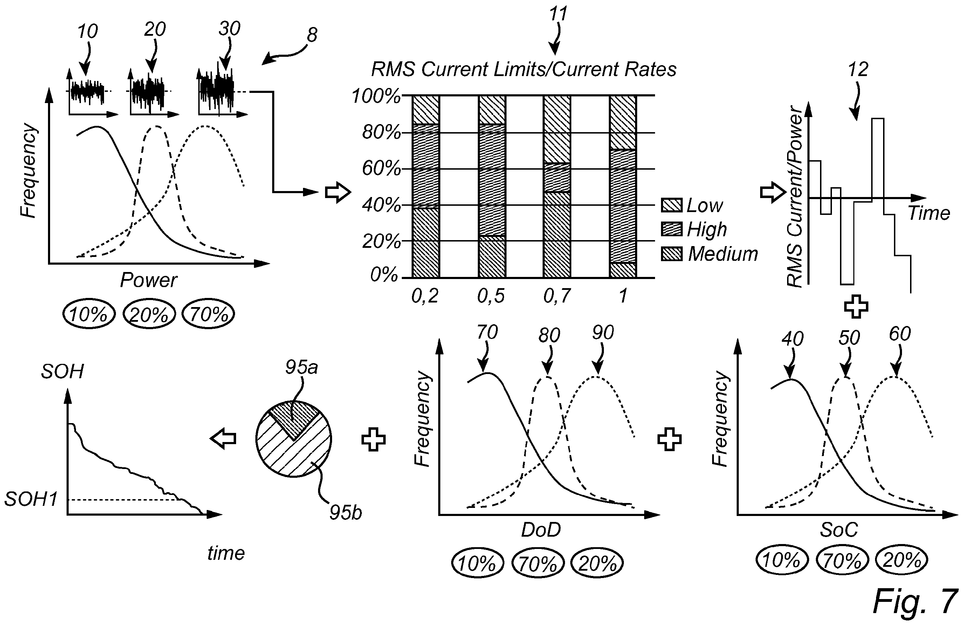

Step S104 includes, categorizing, by the control unit 100, the vehicle fleet data into a set of power usage profiles 10, 20, 30 depending on an expected amount of power usage determined from the vehicle fleet data. Fig. 7 illustrates a functional flow-chart of embodiments of the invention. Here, the vehicle fleet data 8 is shown as a distribution according to the three different profiles 10, 20, 30 over the power usage. In this specific example, the vehicle fleet data is categorized, by analysing the histogram, into low power usage, here being 10% of the users, medium power used by 20% of the users, and high-power usage, here being used by 70% of the users. In other words, in this example, the set of profiles comprises three types or levels of vehicle usage and their relative proportions are determined by categorizing the vehicle fleet data 8.

Categorizing the vehicle fleet data may be performed by processing the vehicle fleet data in a neural network, although other statistical or empirical methods are also envisaged.

Based on the distribution of the power usage profiles 10, 20, 30, the control unit is configured to calculate, in step S106, a time dependent averaged current profile 12. In fig. 7, the diagram 11 shows the percentage contribution from each of the usage profiles 10, 20, 30, to different normalized current rates or limits of 0.2, 0.5, 0.7, and 1. The time dependent averaged electrical current or power profile 12 is preferably calculated by calculating a root-mean-square of the categorized vehicle fleet data 10, 20, 30. The time dependent averaged current profile 12 includes respective proportions of power usage as determined from categorizing the vehicle fleet data 8. In the depicted example, the time dependent averaged current profile 12 includes respective proportions of power usage including 10% low power usage, 20% medium power usage, and 70% high power usage. The proportions may be split over corresponding time durations of the time dependent averaged current profile 12, e.g., for 10% of the time lower power is applied, for 20% of the time medium power is applied, and for 70% or the time high power is applied. The proportions may also be superpositioned in the time dependent averaged current profile 12.

The control unit 100 is configured to control an electrical current or power source to apply, in step S108, the time dependent averaged current profile 12 to an electrical energy storage cell 3 to age the electrical energy storage cell 3 to a predetermined state of health (SOH) level SOH1. This state of health level SOH1 is set so that the electrical energy storage performance at this level of SOH is not significantly degraded.

Once at the state of health level SOH1, the control unit 100 is configured to determine, in step S110, the power or current limit 14 for the electrical energy storage cell 3. The power or current limit 14 is output from the control unit and stored in a memory 17. The control unit 100 is either hardwired or wirelessly connected to the memory storage device 17 and the power supply for applying the time dependent averaged current profile 12 to the electrical energy storage cell 3.

The power or current limit 14 are subsequently applied to the battery management system 10 of the vehicle before deployment and usage. The control unit 100 may employ methods such as hybrid pulse power characterization (HPPC) or I-V methods for determining the power or current limit.

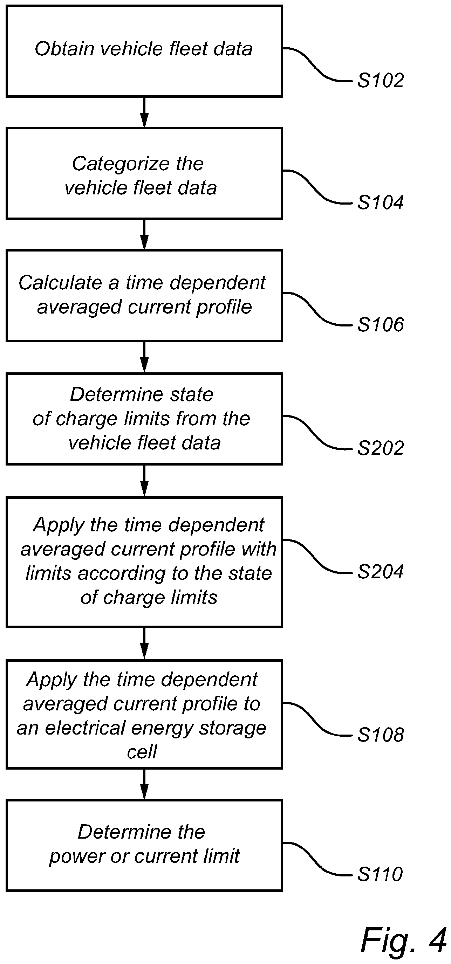

To further improve the relation between real-world usage and the determined power or current limit further parameters may be taken into account. Turning now to the flow-chart in fig. 4, the control unit 100 may additionally determine state of charge limits from the vehicle fleet data in step S202. The state of charge limits reflect the typical state of charge as observed in the usage of the vehicles 1 in the geographical area 6. Typically, the state of charge usage from the vehicle fleet data is categorized into a set of state of charge profiles 40, 50, 60 depending on state of charge usage derived from the vehicle fleet data as conceptually illustrated in fig. 7. The state of charge profiles 40, 50, 60 include low state of charge 40, medium state of charge 50, and high state of charge 60. For example, 10% of the vehicles may belong to the low state of charge profile 40, e.g., 10% of the users operate their vehicles in low SoC regions. 70% of the vehicles may belong to the medium state of charge profile 50, e.g., 70% or the users operate their vehicles in medium SoC regions. 20% of the vehicles may belong to the high state of charge profile 60, e.g., 20% of the users operate their vehicles in high SoC regions. State of charge limits are determined from the categorized state of charge usage for each profile 40, 50, 60.

The state of charge limits are superimposed when applying the time dependent averaged current profile 12. In other words, the time dependent averaged current profile 12 may be applied with current and/or power limits according to the state of charge limits in step S202. For example, the time dependent averaged current profile 12 is applied so that the aged cell is at SOCs according to the derived limits for corresponding periods of time. More precisely, with the example discussed herein, the time dependent averaged current profile 12 will be applied so that the aged battery cell 3 is at low SoC for 10% of the time, at medium SoC for 70% of the time, and at high SoC for 20% or the time.

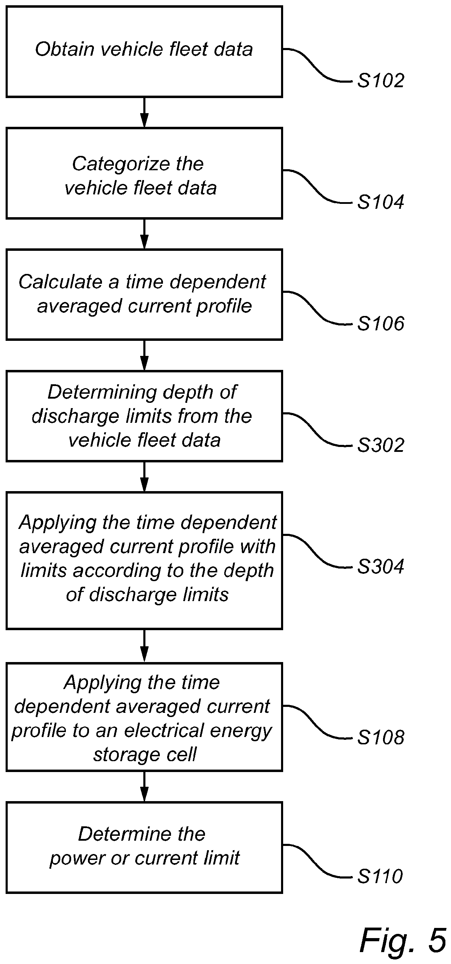

The control unit 100 may be configured to superimpose other limits when applying the time dependent averaged current profile 12. Turning to fig. 5, the control unit 100 may determine a depth of discharge limits from the vehicle fleet data in step S302 and apply the time dependent averaged current profile 12 with limits according to the depth of discharge limits in step S304. This is performed in an analogous way to the above discussion about state of charge limits. For example, the depth of discharge data from the vehicle fleet data is categorized into a set of depth of discharge limits profiles 70, 80, 90 conceptually illustrated in fig. 7 depending on the depth of discharge usage derived from the vehicle fleet data. The depth of discharge limits reflects energy usage on the daily/yearly usage observed in the vehicle fleet data 8 obtained from the vehicles 1. The depth of discharge profiles 70, 80, 90 include low depth of discharge 70, e.g., 10% of the users discharge the batteries according to a low depth of discharge, medium depth of discharge 80, e.g., 70% of the users discharge the batteries according to a medium depth of discharge, and high depth of discharge 90, e.g., 20% of the users discharge the batteries according to a high depth of discharge. Stated otherwise, 10% of the vehicles may belong to the low depth of discharge profile 70, 70% of the vehicles may belong to the medium depth of discharge profile 80, and 20% of the vehicles may belong to the high depth of discharge profile 90. Depth of discharge limits are determined from the categorized depth of discharge usage for each profile 70, 80, 90 based on corresponding current and voltages derived from the depth of discharge profiles.

The time dependent averaged current profile 12 is applied so that the cell 3 being aged discharged at depths according to the derived depth of discharge limits for corresponding periods of time. According to the example shown in fig. 7, when taking the depth of discharge profiles 70, 80, 90 into account, the time dependent averaged current profile 12 is applied so that for 10% of the time the battery cell 3 is discharged according to the low depth of discharge, for 70% of the time the battery cell 3 is discharged according to the medium depth of discharge, and for 20% of the time the battery cell 3 is discharged according to the high depth of discharge.

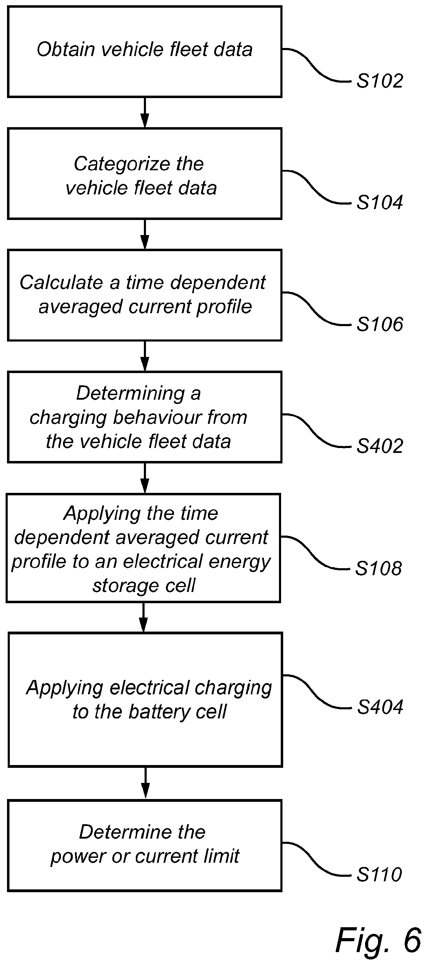

In yet another embodiment, further parameters are included as illustrated in step S402 in fig. 6. In this step S402, the control unit 100 is configured to determine a charging behaviour from the vehicle fleet data, and apply, in step S404, charging of the battery cell with limits or rates according to the charging behaviour. The charging behaviour may include a distribution of charging rates 95 including at least two different charging rates 95a and 95b and the relative amount between them. For example, the control unit 100 may extract charging data from the vehicle fleet data 8 that indicates charging rates typically used when charging vehicle propulsion batteries in the geographical area 6. For example, in fig 7 it is conceptually shown that a larger proportion 95b of charging events may be fall under relatively slow charging rates and relatively smaller proportion 95a may fall under relatively faster charging rates. From the distribution of charging rates, charging of the battery cell during the ageing is be superimposed on the time dependent averaged current profile 12 according to the distribution of charging rates.

Overall, the state of charge limits, the depth of discharge limits and the limits derived from the charging behaviour data may be superimposed on the time dependent averaged current profile 12.

A control unit may include a microprocessor, microcontroller, programmable digital signal processor or another programmable device. Thus, the control unit comprises electronic circuits and connections (not shown) as well as processing circuitry (not shown) such that the control unit can communicate with different parts of the truck such as the brakes, suspension, driveline, in particular an electrical engine, an electric machine, a clutch, and a gearbox in order to at least partly operate the truck. The control unit may comprise modules in either hardware or software, or partially in hardware or software and communicate using known transmission buses such as CAN-bus and/or wireless communication capabilities. The processing circuitry may be a general purpose processor or a specific processor. The control unit comprises a non-transitory memory for storing computer program code and data upon. Thus, the skilled addressee realizes that the control unit may be embodied by many different constructions.

The control functionality of the present disclosure may be implemented using existing computer processors, or by a special purpose computer processor for an appropriate system, incorporated for this or another purpose, or by a hardwire system. Embodiments within the scope of the present disclosure include program products comprising machine-readable medium for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, CD-ROM or other optical disk storage, magnetic disk storage or other magnetic storage devices, or any other medium which can be used to carry or store desired program code in the form of machine-executable instructions or data structures, and which can be accessed by a general purpose or special purpose computer or other machine with a processor. When information is transferred or provided over a network or another communications connection (either hardwired, wireless, or a combination of hardwired or wireless) to a machine, the machine properly views the connection as a machine-readable medium. Thus, any such connection is properly termed a machine-readable medium. Combinations of the above are also included within the scope of machine-readable media. Machine-executable instructions include, for example, instructions and data which cause a general purpose computer, special purpose computer, or special purpose processing machines to perform a certain function or group of functions.

Although the figures may show a sequence the order of the steps may differ from what is depicted. Also two or more steps may be performed concurrently or with partial concurrence. Such variation will depend on the software and hardware systems chosen and on designer choice. All such variations are within the scope of the disclosure. Likewise, software implementations could be accomplished with standard programming techniques with rule based logic and other logic to accomplish the various connection steps, processing steps, comparison steps and decision steps. Additionally, even though the invention has been described with reference to specific exemplifying embodiments thereof, many different alterations, modifications and the like will become apparent for those skilled in the art.

It is to be understood that the present invention is not limited to the embodiments described above and illustrated in the drawings; rather, the skilled person will recognize that many changes and modifications may be made within the scope of the appended claims.

## Claims

1. A method for estimating a power or current limit for an electrical energy storage system (2), the method comprising:
obtaining (S102) vehicle fleet data indicating power usage of a fleet (4) of vehicles (1) in a geographical area (6);
categorizing (S104) the vehicle fleet data into a set of power usage profiles (10, 20, 30) depending on an expected amount of power usage determined from the vehicle fleet data;
calculating (S106) a time dependent averaged current profile (12) from a distribution of the power usage profiles; and
applying (S108) the time dependent averaged current profile (12) to an electrical energy storage cell (3) to age the electrical energy storage cell to a predetermined state of health, and
determining (S110) the power or current limit (14) for the electrical energy storage cell.

2. The method according to claim 1, comprising:
determining (S202) state of charge limits from the vehicle fleet data, and
applying (S204) the time dependent averaged current profile with limits according to the state of charge limits.

3. The method according to claim 2, comprising:
categorizing state of charge usage from the vehicle fleet data into a set of state of charge profiles (40, 50, 60) depending on state of charge usage derived from the vehicle fleet data, and
determining state of charge limits from the categorized state of charge usage.

4. The method according to any one of the preceding claims, comprising:
determining (S302) depth of discharge limits from the vehicle fleet data, and
applying (S304) the time dependent averaged current profile with limits according to the depth of discharge limits.

5. The method according to claim 4, comprising:
categorizing depth of discharge from the vehicle fleet data into a set of depth of discharge limits profiles (70, 80, 90) depending on depth of discharge usage derived from the vehicle fleet data, and
determining depth of discharge limits from the categorized depth of discharge limits usage.

6. The method according to any one of the preceding claims, comprising:
determining (S402) a charging behaviour from the vehicle fleet data, and
applying (S404) charging to the battery cell according to the charging behaviour.

7. The method according to claim 6, wherein the charging behaviour includes a distribution of charging rates (95) including at least two different charging rates.

8. The method according to any one of the preceding claims, wherein calculating a time dependent averaged current profile comprises calculating a root-mean-square of the categorized vehicle fleet data.

9. The method according to any one of the preceding claims, wherein the set of profiles comprises three types or levels of vehicle usage.

10. The method according to any one of the preceding claims, wherein the vehicle fleet data is retrieved from a server (102).

11. The method according to any one of the preceding claims, wherein the vehicle fleet data is field data collected from vehicles operating in real-world conditions operated by multiple drivers in the geographical area.

12. A computer program comprising program code means for performing the steps of any of claims 1-11 when said program is run on a computer.

13. A computer readable medium carrying a computer program comprising program code means for performing the steps of any of claims 1-11 when said program product is run on a computer.

14. A control unit (100) for estimating a power or current limit for an electrical energy storage system, the control unit is configured to perform the steps of the method according to any of claims 1-11.

15. An electrical energy storage system (2) comprising at least one electrical energy storage cell (3), wherein an power or an current limit for the electrical energy storage cell (3) is determined using the steps of the method according to any one of claims 1-11.
